# FASCICULE DE BREVET EUROPEEN

(11) **EP 2 363 889 B1**
(45) Date de publication et mention de la délivrance du brevet: **04.04.2018**
(21) Numéro de dépôt: 11155359.0
(22) Date de dépôt: 22.02.2011
(51) Int. Cl.: H01L 29/06, H01L 29/74, H01L 29/747, H01L 29/08

(54) **Composant de puissance verticale haute tension**
Vertikales Hochspannungs-Leistungsbauelement
High voltage vertical power device

(30) Priorité: 01.03.2010 FR 1051437
(43) Date de publication de la demande: 07.09.2011
(73) Titulaire: STMicroelectronics (Tours) SAS, 37100 Tours (FR)
(72) Inventeur: Menard, Samuel, 37000 Tours (FR); Ihuel, François, 37000 Tours (FR)
(74) Mandataire: Thibon, Laurent

(56) Documents cités:
- EP-A1- 0 702 412
- WO-A1-2009/053912
- WO-A2-2005/008760
- JP-A- 2004 336 008
- US-A- 3 549 961
- US-A1- 2004 082 140
- US-A1- 2006 267 091
- US-A1- 2010 025 809

## Description

### Domaine de l'invention

La présente invention concerne un composant de puissance vertical susceptible de supporter une tension élevée (supérieure à 500 V) et plus particulièrement la structure de la périphérie d'un tel composant.

### Exposé de l'art antérieur

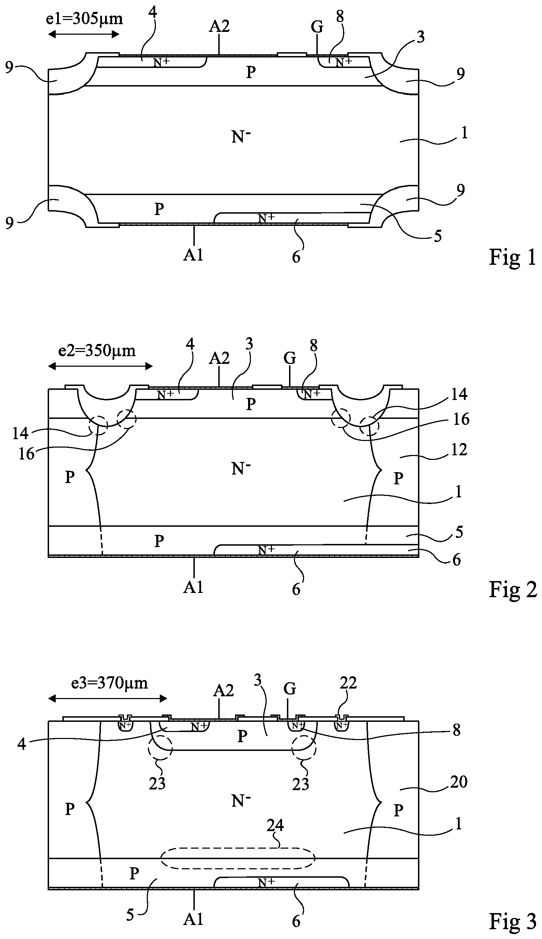

Les figures 1, 2 et 3 représentent diverses façons de constituer la périphérie d'un composant de puissance vertical haute tension pour lui permettre de tenir des tensions élevées.

Dans ces figures, on a représenté un triac comprenant un substrat 1 faiblement dopé, couramment de l'ordre de 10¹⁴ à 10¹⁵ atomes/cm³, dont les faces supérieure et inférieure comprennent des couches ou régions 3 et 5 dopées de type P. La couche supérieure 3 contient une région 4 fortement dopée de type N et la couche inférieure 5 contient une région 6 fortement dopée de type N dans une zone sensiblement complémentaire de celle occupée par la région 4. Une électrode A1 revêt la face inférieure du composant et est en contact avec les régions 5 et 6. Une électrode de face supérieure A2 est en contact avec la région 4 et une partie de la région 3. Dans cette région 3 est également formée une région de petite étendue 8 fortement dopée de type N et une électrode de gâchette G recouvre la région 8 et une partie de la région 3. Ainsi, quelle que soit la polarité entre les électrodes A1 et A2, si une commande de gâchette est fournie, le composant devient passant. La conduction se fait de l'électrode A1 vers l'électrode A2 par un thyristor vertical comprenant les régions 5, 1, 3 et 4, ou de l'électrode A2 vers l'électrode A1 par un thyristor vertical comprenant les régions 3, 1, 5 et 6. L'épaisseur et le niveau de dopage du substrat 1 sont calculés pour que le triac, à l'état bloqué, puisse tenir des tensions élevées, par exemple des tensions supérieures à 600 à 800 volts. Il faut alors éviter que des claquages se produisent au niveau des extrémités du composant.

La figure 1 représente une structure périphérique dite mesa pour éviter de tels claquages. Une tranchée latérale annulaire plus profonde que les régions P 3 et 5 est formée à la périphérie de chacune des deux faces du substrat. Ces tranchées sont remplies d'un verre de passivation 9. En pratique des tranchées sont initialement formées sur une tranche de silicium entre deux composants avant découpe de la tranche en composants individuels. De nombreuses études ont été faites sur de tels composants de puissance verticaux de type mesa. Si un claquage survient, il se produit dans les zones ou les jonctions PN⁻ coupent les tranchées isolées 9. Dans les meilleurs conditions, c'est-à-dire quand l'angle selon lequel les tranchée remplies de verre coupent les jonctions entre le substrat et les couches 3 et 5 est convenablement choisi, et quand la qualité du verre est optimisée, on doit pour obtenir une tenue en tension supérieure à 800 volts prévoir une distance e1 entre le bord du composant et la limite de la glassivation au moins égale à 300 µm. Ceci réduit d'autant la surface disponible pour les électrodes du composant de puissance ; ou bien, pour des valeurs données de surface des électrodes, ceci augmente la surface du composant et donc son coût.

Un inconvénient particulier des structures mesa est que, étant donné que le verre de passivation n'a jamais le même coefficient de dilatation thermique que le silicium, l'interface entre le verre et le silicium vieillit mal et, en cas de claquage accidentel, si la tension aux bornes du composant dépasse la limite autorisée, le composant n'est plus opérationnel.

La figure 2 représente une autre structure classique de périphérie de composant de puissance. Un sillon rempli d'un verre de passivation est présent du côté de la face supérieure. Le composant est entouré d'un mur diffusé 12 fortement dopé de type P formé à partir des faces supérieure et inférieure et le sillon s'étend entre le mur 12 et la couche 3 de type P, sensiblement de la façon représentée. Ainsi, toutes les zones de tenue en tension sont regroupées du côté de la face supérieure du composant. C'est au niveau de la périphérie de la jonction entre le mur 12 et le substrat 1, du côté du sillon, dans la zone désignée par la référence 14, que sont susceptibles de se produire des claquages quand l'électrode inférieure A1 est négative par rapport à l'électrode supérieure A2 (claquage dit inverse) ; et c'est au niveau de la périphérie de la jonction entre le substrat 1 et la couche 3, du côté du sillon, dans la zone désignée par la référence 16, que sont susceptibles de se produire des claquages quand l'électrode inférieure A1 est positive par rapport à l'électrode supérieure A2 (claquage dit direct).

Cette structure donne de bons résultats, et simplifie la réalisation de l'électrode inférieure A1, mais la distance e2 entre le bord du composant et la limite de l'électrode A2 est plus grande que dans le cas précédent, par exemple de 350 µm pour tenir une tension supérieure à 800 volts. De plus, comme dans le cas précédent, l'interface entre le silicium et le verre de passivation reste problématique.

De plus, ce procédé nécessite un nombre de masques plus important que celui de la structure précédente.

La figure 3 représente une structure de passivation en technologie dite "planar". Comme dans le cas de la figure 3, la structure est entourée d'un mur annulaire diffusé fortement dopé de type P à sa périphérie. Pour tenir la tension, on prévoit une certaine distance entre la limite de la couche 3 de type P et le mur périphérique 20. Si un claquage survient, il se produit dans les régions 23 de courbure du caisson P 3 ou dans la région 24 de jonction entre la couche P 5 et le substrat 1.

Un avantage de cette structure est qu'un claquage n'est pas nécessairement destructif pour le composant. Toutefois, cette structure présente l'inconvénient de nécessiter un anneau d'arrêt de canal 22 à la périphérie de la face supérieure dans la région N1 entre la limite de la région P 3 et la limite du mur d'isolement 20. Ceci entraîne l'inconvénient de nécessiter une distance de garde e3 relativement élevée entre le bord du composant et la limite de l'électrode A2, par exemple, de l'ordre de 370 µm pour tenir une tension supérieure à 800 volts. Le document US 3 549 961 A divulgue un composant de puissance de type mesa dans lequel une rainure d'isolation est remplie d'un matériau de passivation.

Le document JP 2004 336008 A divulgue un composant de puissance dans lequel une structure d'isolation dans la zone de périphérie comprend une tranché dont les parois sont isolées. La tranché selon JP 2004 336008 A est ensuite remplie du silicium polycristallin. Le silicium polycristallin dopé bore sert d'une source de dopants pour former une région isolante annulaire sous-jacente.

Des composants de puissance et les structures d'isolation correspondantes sont également connus des documents US 2010/025809 A1, WO 2009/053912 A1, WO 2005/008760 A2, EP 0 702 412 A1, US 2006/267091 A1 et US 2004/082140 A1.

### Résumé

Ainsi, il existe un besoin pour une structure périphérique de composant de puissance qui soit moins étendue que les diverses structures connues.

Il existe également un besoin pour une telle structure qui évite une dégradation du composant en cas de surtension accidentelle très élevée entraînant un claquage.

Ainsi, un mode de réalisation de la présente invention prévoit un composant de puissance vertical haute tension selon la revendication 1. D'autres modes de réalisation sont définis dans les revendications dépendantes.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1 à 3 représentent diverses structures connues de composants de puissance verticaux ; et
la figure 4 représente un exemple de structure de composant vertical de puissance selon un mode de réalisation de la présente invention.

Comme cela est habituel dans la représentation des composants semiconducteurs, les diverses figures ne sont pas tracées à l'échelle.

### Description détaillée

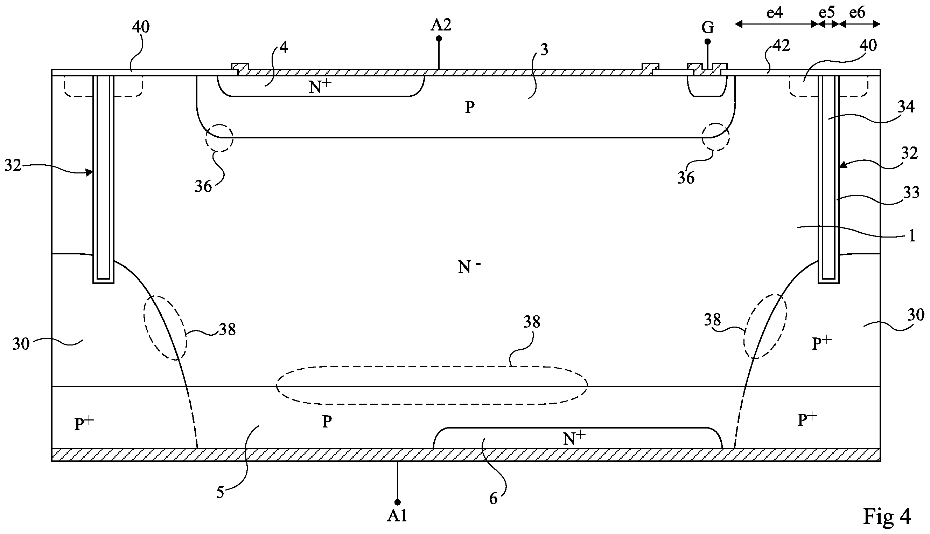

La figure 4 représente un triac dont les différents éléments sont désignés par les mêmes références que les éléments correspondants des figures 1, 2 et 3.

A la périphérie du composant, on trouve du côté de la face inférieure, une portion de mur diffusé 30 fortement dopée de type P traversant la couche inférieure de type P 5 et pénétrant sur une profondeur dans le substrat 1, cette profondeur étant du tiers à la moitié de l'épaisseur de ce substrat.

Du côté de la face supérieure, à la périphérie du composant, une rainure annulaire droite et profonde 32 rejoint la région diffusée 30. Cette rainure 32 a une largeur de 5 à 10 µm et est isolée. Elle comprend par exemple à sa périphérie une couche d'oxyde 33 et dans sa partie centrale du silicium non dopé 34.

Du côté de la face supérieure, la région dopée de type P 3 s'étend jusqu'à une distance e4 de la rainure. La rainure a une largeur e4 et la distance entre la rainure et le bord du composant est égale à e6.

Une couche supérieure de SiO₂ (42) revêt toutes les surfaces du composant non occupées par une métallisation.

Dans une telle structure, les claquages directs peuvent se produire dans la région 36 de courbure de la couche 3 de type P et les claquages inverses peuvent se produire dans la région 38 quasiment tout le long de la jonction inférieure formée par la couche 5 et le substrat 1.

Une telle structure présente de très nombreux avantages. D'une part, la région diffusée 30 formée à partir de la face inférieure n'a pas besoin de rejoindre une région diffusée supérieure et s'étend sur une profondeur inférieure à la moitié et supérieure au tiers de l'épaisseur du substrat, par exemple sur une épaisseur de l'ordre du tiers de l'épaisseur du substrat, par exemple sur une profondeur de l'ordre de seulement 100 µm.

De préférence, la tranchée 32 s'étend sur une profondeur de l'ordre de 20 µm à l'intérieur de la région diffusée 30.

Dans une telle structure, étant donné que les claquages susceptibles de se produire se produisent en profondeur dans le substrat, on n'a pas besoin de prévoir de régions d'arrêt de canal. En fait, on constate, que la distance entre la périphérie du composant et la limite de la région 3 peut être seulement de l'ordre de 250 µm, avec une tranchée d'une largeur de l'ordre de 10 µm, pour obtenir une tension supérieure à 800 volts. Cette valeur est nettement inférieure à toutes les valeurs des dispositifs connus.

D'autre part, un claquage accidentel provoqué par une surtension très élevée ne produit pas de destruction du composant.

Eventuellement, on pourra prévoir une zone N plus fortement dopée 40 au voisinage du débouché de la rainure du côté de la surface supérieure pour contrôler l'extension de la zone de charge d'espace (notamment pour la fiabilité de la jonction directe) et éviter tout phénomène d'inversion de surface.

Ainsi, la structure selon la présente invention permet de réduire nettement la surface occupée par la périphérie du composant en supportant efficacement les claquages.

La présente invention a été décrite précédemment dans le cas où le composant de puissance était un triac. On comprendra qu'une structure analogue peut s'appliquer à tout autre type de composant de puissance vertical connu.

## Revendications

1. Composant de puissance vertical haute tension comprenant un substrat semiconducteur (1) faiblement dopé d'un premier type de conductivité et, du côté d'une face supérieure, une couche semiconductrice supérieure (3) du second type de conductivité ne s' étendant pas jusqu'à la zone périphérique du composant, dans lequel la zone périphérique du composant comprend :
du côté de la face inférieure, une région diffusée annulaire (30) du deuxième type de conductivité s'étendant sur le tiers à la moitié de l'épaisseur du composant, cette région s'étendant à partir de la face inférieure du substrat ; et
du côté de la face supérieure, une rainure annulaire (32) traversant le substrat jusqu'à pénétrer dans une partie supérieure de ladite région annulaire (30), les parois latérales de cette rainure étant revêtus d'un matériau isolant (33);
**caractérisé en ce que**
le fond de cette rainure (32) est revêtu du matériau isolant (33).

2. Composant de puissance vertical haute tension selon la revendication 1, dans lequel la rainure (32) est isolée latéralement par une couche d'oxyde de silicium (33) et est remplie de silicium non dopé (34).

3. Composant de puissance vertical haute tension selon la revendication 1 ou 2, constituant un triac, dans lequel :
une première région (4) fortement dopée du premier type de conductivité s'étend dans une partie de ladite couche semiconductrice supérieure (3), ladite première région (4) et une partie de ladite couche semiconductrice supérieure (3) étant en contact avec une première électrode (A2) ; et
la face inférieure comprend une couche semiconductrice inférieure (5) dopée du second type de conductivité, dans laquelle est formée une seconde région (6) du premier type de conductivité, sensiblement complémentaire en projection de la première région (4).

4. Composant de puissance vertical haute tension selon l'une quelconque des revendications 1 à 3, dans lequel la rainure (32) a une largeur de l'ordre de 5 à 10 µm.

5. Composant de puissance vertical haute tension selon l'une quelconque des revendications 1 à 4, dans lequel la rainure (32) a une profondeur de l'ordre de 100 à 200 µm.

6. Composant de puissance vertical haute tension selon l'une quelconque des revendications 1 à 5, susceptible de supporter une tension supérieure à 800 volts, dans laquelle la distance entre la limite de ladite couche semiconductrice supérieure (3) et le bord du composant est de l'ordre de 250 µm.

## Patentansprüche

1. Eine Hochspannung-Vertikal-Leistungskomponente, die ein leicht dotiertes Halbleitersubstrat (1) eines ersten Leitfähigkeitstyps, und an der Seite einer oberen Fläche, eine obere Halbleiterschicht (3) eines zweiten Leitfähigkeitstyps aufweist, die sich nicht ganz zu der Peripherie der Komponente erstreckt, wobei die Peripherie der Komponente Folgendes aufweist:
an der unteren Flächenseite einen ringförmigen diffundierten Bereich (30) des zweiten Leitfähigkeitstyps, der sich von einem Drittel bis zur Hälfte der Dicke der Komponente erstreckt, wobei dieser Bereich sich von der unteren Flächenseite des Substrats erstreckt; und
an der oberen Flächenseite eine isolierte ringförmige Nut (32), die das Substrat kreuzt, um in einen oberen Teil des ringförmigen Bereichs (30) einzudringen, wobei die seitliche Wand dieser Nut durch ein isolierendes Material (33) abgedeckt wird, **dadurch gekennzeichnet, dass** der Boden dieser Nut (32) durch das isolierende Material (33) abgedeckt ist.

2. Hochspannung-Vertikal-Leistungskomponente nach Anspruch 1, wobei die Nut (32) seitlich durch eine Siliziumoxidschicht (33) isoliert und mit undotiertem Silizium (34) gefüllt ist.

3. Hochspannung-Vertikal-Leistungskomponente nach Anspruch 1 oder 2, die ein Triac bildet, wobei:
sich ein erster hochdotierter Bereich (4) des ersten Leitfähigkeitstyps in einen Teil der Halbleiterschicht (3) erstreckt, wobei der erste Bereich (4) und ein Teil der Halbleiterschicht (3) in Kontakt mit einer ersten Elektrode (A2) ist; und
die untere Seite eine geringer dotierte Halbleiterschicht (5) des zweiten Leitfähigkeitstyps aufweist, in dem ein zweiter Bereich (6) des ersten Leitfähigkeitstyps gebildet ist, und zwar im Wesentlichen komplementär zu dem ersten Bereich (4), wenn er in der Projektionsansicht ist.

4. Hochspannung-Vertikal-Leistungskomponente nach einem der Ansprüche 1 bis 3, wobei die Nut (32) eine Breite in der Größenordnung von 5 bis 10 µm besitzt.

5. Hochspannung-Vertikal-Leistungskomponente nach einem der Ansprüche 1 bis 4, wobei die Nut (32) eine Tiefe in der Größenordnung von 100 bis 200 µm besitzt.

6. Hochspannung-Vertikal-Leistungskomponente nach einem der Ansprüche 1 bis 5, die geeignet ist einer Spannung zu widerstehen, die größer als 800 Volt ist, wobei der Abstand zwischen der Grenze der oberen Halbleiterschicht (3) und der Peripherie der Komponente in der Größenordnung von 250 µm ist.

## Claims

1. A high-voltage vertical power component comprising a lightly-doped semiconductor substrate (1) of a first conductivity type and, on the side of an upper surface, an upper semiconductor layer (3) of the second conductivity type which does not extend all the way to the component periphery, wherein the component periphery comprises:
on the lower surface side, a ring-shaped diffused region (30) of the second conductivity type extending across from one third to half of the component thickness, this region extending from the lower surface side of the substrate; and
on the upper surface side, an isolated ring-shaped groove (32) crossing the substrate to penetrate into an upper portion of said ring-shaped region (30), the lateral wall of this groove being covered by an insulating material (33), **characterized in that** the bottom of this groove (32) is covered by the insulating material (33).

2. The high-voltage vertical power component of claim 1, wherein the groove (32) is laterally insulated by a silicon oxide layer (33) and is filled with undoped silicon (34).

3. The high-voltage vertical power component of claim 1 or 2, forming a triac, wherein:
a first heavily-doped region (4) of the first conductivity type extends in a portion of said upper semiconductor layer (3), said first region (4) and a portion of said upper semiconductor layer (3) being in contact with a first electrode (A2); and
the lower surface comprises a lower doped semiconductor layer (5) of the second conductivity type, in which is formed a second region (6) of the first conductivity type, substantially complementary to the first region (4) when seen in projection.

4. The high-voltage vertical power component of any of claims 1 to 3, wherein the groove (32) has a width on the order of from 5 to 10 µm.

5. The high-voltage vertical power component of any of claims 1 to 4, wherein the groove (32) has a depth on the order of from 100 to 200 µm.

6. The high-voltage vertical power component of any of claims 1 to 5, capable of withstanding a voltage greater than 800 volts, wherein the distance between the limit of said upper semiconductor layer (3) and the component periphery is on the order of 250 µm.
